# EUROPEAN PATENT SPECIFICATION

(11) **EP 4 190 460 B1**
(45) Date of publication and mention of the grant of the patent: **17.12.2025**
(21) Application number: 21851226.7
(22) Date of filing: 30.07.2021
(51) Int. Cl.: B21D 5/12, G06F 30/10, B21C 37/08

(54) **METHOD AND DEVICE FOR PRODUCING METAL PIPE**
VERFAHREN UND VORRICHTUNG ZUR HERSTELLUNG EINES METALLROHRS
PROCÉDÉ ET DISPOSITIF DE PRODUCTION D'UN TUYAU MÉTALLIQUE

(30) Priority: 31.07.2020 JP 2020130667
(43) Date of publication of application: 07.06.2023
(73) Proprietor: Nakata Manufacturing Co., Ltd., Osaka-shi, Osaka 532-0027 (JP)
(72) Inventor: NAKANO, Tomoyasu, Osaka-shi, Osaka 532-0027 (JP); NISHII, Masato, Osaka-shi, Osaka 532-0027 (JP); SATO, Takeyuki, Osaka-shi, Osaka 532-0027 (JP); YIN, Jilong, Osaka-shi, Osaka 532-0027 (JP); WANG, Feizhou, Osaka-shi, Osaka 532-0027 (JP); HARUYAMA, Shunichi, Osaka-shi, Osaka 532-0027 (JP)
(74) Representative: Wächtershäuser & Hartz Patentanwaltspartnerschaft mbB
(86) International application number: PCT/JP2021/028412
(87) International publication number: WO 2022/025272

(56) References cited:
- DE-T2- 69 926 406
- JP-A- 2000 000 616
- JP-A- 2000 084 619
- JP-A- 2016 185 560
- JP-A- H07 275 954
- JP-A- H08 187 516
- US-A- 4 770 019

## Description

### Technical Field

The present invention relates to roll forming of forming a metal strip from a plate shape into a semi-circular shape and a circular shape continuously using a forming roll available for multi-use within a several-fold range in diameter ratio and performing butt welding at opposite edge portions of the metal strip to form a welded pipe, and relates to a manufacturing apparatus and a manufacturing method for manufacturing a welded pipe capable of applying thrust required for the forming reliably to a forming target raw material in response to a difference in product dimension or a difference in metal type and achieving forming with high efficiency and high accuracy without causing pushing and pulling of the material in a line direction between forming roll stands.

### Background Art

The present inventors previously filed a PCT application (PCT/JP2021/014863) intended for a method of manufacturing a metal pipe allowing automatic operation using a pipe mill for manufacturing a metal pipe, and suggested a manufacturing method (smart mill) that achieves required forming while automatically moving the position of a forming tool to a predetermined position to be arranged in a stand of the pipe mill when a manufacturing condition such as the dimension of a metal strip is changed at the time of initial threading of a forming target raw material or changing of the dimension of a metal strip necessitated by so-called dimension changing, for example.

In order to perform the above-described initial threading automatically in a pipe mill using a multi-use roll required to be adjusted in position in a stand for the forming roll to be used as a multi-use roll responsive to a difference in diameter within a certain range, a pipe mill having forming roll configurations all identified was assumed by designing a roll flower in such a manner as to perform edge bending in the pipe mill entirely using a multi-use forming roll and then perform circular bending, for example.

Regarding forming steps performed using the forming rolls in this pipe mill, all processes of ideally forming a plate that is a forming target raw material having a certain ideal property into a round pipe were analyzed by forming simulation conducted using a three-dimensional elastoplastic deformation finite element method, for example, and result of the analysis was grasped as a forming process according to an ideal model. Then, this forming process was grasped as correlation between a deformed shape value (material sectional shape, for example) of an entire strip-shaped material extending continuously from an entry guide stand EG to a Turk's head stand TH and positional information about each roll at all forming roll stands from the entry guide stand EG to the Turk's head stand TH.

If a forming process for an integrated object formed from a plate-like shape into a pipe shape acquired from the forming simulation analysis on a metal strip having a certain type, a dimension, and a manufacturing history is given correlation determined by a difference in dimension of this material between a material sectional shape and a roll position and if this correlation is evaluated as a deformed shape value (an edge position, a width dimension, a height dimension as a sectional shape, for example) of the forming target material at a certain measurement position in the pipe mill, ideal roll positions for forming rolls at roll stands in front of and behind a measurement position are obtained on the basis of the correlation in operation within an assumed range of multi-use.

In addition to a difference in type or dimension, in response to the individuality of a forming target material, specifically, individuality unique to a metal strip to be used such as dimensional error, a hot rolling history, a material difference, or fluctuation in a line direction of the metal strip, an actual forming process applied during forming in a pipe mill having a predetermined configuration can be determined to differ from that according to an ideal model defining an ideal forming process for a metal strip by giving consideration to the individuality of the pipe mill.

In response to this, by measuring a difference between a model during real operation and the ideal model as a deformed shape value of the metal strip being formed and by making comparison and prediction of predicting that adjustment of the position of a forming roll will become necessary as a result of the difference in forming process from the ideal model, it becomes possible to select a forming roll and make positional adjustment for this forming roll required to be corrected for realizing a forming process unique to the metal strip during operation.

In developing the above-described smart mill, various experiments were conducted on an FFX mill (Patent Literature 1) of the applicant available for manufacturing metal pipes of a range from large diameters to small diameters within an outer diameter ratio of 1:3 without roll changing. This FFX mill is characterized in that, as all rolls including a breakdown BD roll are multi-use rolls, an involute roll caliber with a continuously changing curvature is employed and fit bending of making a bend while making a fit to an upper roll is used to form ideal roll calibers responsive to various product outer diameters or thicknesses.

Upper and lower forming rolls move horizontally so as to extend or contract in response to a plate width or move up and down in response to a thickness or a pass line. An upper roll in a breakdown first stage is configured to swing so as to change a contact surface with a raw plate. An employed configuration is such that a roll position is adjusted in response to various product outer diameters or thicknesses.

A method of manufacturing the smart mill allowing automatic control operation has favorable matching to various product outer diameters or thicknesses that is almost indispensable for the FFX mill having a configuration for roll position adjustment. This achieves automatic operation during initial threading and responds to the individuality of a forming target material easily, thereby realizing automation.

Document DE 699 26 406 T2 shows a manufacturing apparatus for a welded pipe and forms the basis for the preamble of claims 1, 6 and 7.

### Prior Art Literature

### Patent Literature

Patent Literature 1: Japanese Patent No. 4906986

### Summary of Invention

### Problem to be Solved by Invention

Regarding the above-described smart mill, in examining analysis on the forming process using the three-dimensional elastoplastic deformation finite element method with the aim of improving shape performance (forming region or forming curvature) or improving accuracy in edge bending and improving forming performance for higher quality in terms of improvement of butting accuracy between seams resulting from the edge bending or improvement of welding quality, for example, a new problem has been found occurring as a result of employing an involute roll caliber and performing bending and feed driving of a raw material by using a multi-use roll intended for fit bending of making a bend while making a fit to an upper roll.

In a breakdown BD forming section, unless the edge bending (shape property or its accuracy) by the fit bending is not completed reliably, even when forming from a semi-circular shape to an approximately circular shape is finished by circular bending as a next step in a cluster roll CL forming section, welding defect still occurs as a result of shape failure in a butt between edge portions.

More specifically, in a first stage of the breakdown, a point of pinch using upper and lower rolls is set in the vicinity of the edge portions and a raw material is subjected to bending while the raw material is fitted to a particular point of the upper roll.

In stages from a second stage to a fourth stage of the breakdown, while the edge portion previously bent is supported on a side roll, a pinch point is set internally to the portion formed by the upper and lower rolls in the previous stage and the raw material is subjected to bending while the raw material is fitted to a particular point of an inner roll. Here, as the side roll plays the significant function of adjusting a range of the fit, adjusting the position of the side roll in a stand is an extremely important issue. Additionally, unless necessary and sufficient forming load is generated at the side roll, the forming cannot be completed.

### Means of Solving Problem

A systematic technique or a mathematical formula for calculating load (forming reaction force) required for roll forming has yet to be established and only some simple formulas under specific conditions were suggested in 1980s. Forming load may be measured in a real machine by a method of arranging load cells at upper and lower horizontal roll shaft bearings, for example. However, it is difficult to employ this method in the case of a side roll. On the other hand, simulation analysis on a forming process makes it possible to grasp forming load generated at a forming roll and an entry resistance of a raw material received from the forming roll with high accuracy.

The above-described new problem is that, as a forming roll is a multi-use roll, a point where a raw material is pinched with forming rolls is changed by a product size, that forming reaction force received by the forming roll is greatest at the pinch point and a feed diameter making agreement between a traveling speed of the raw material and a roll peripheral speed is near the pinch point, and that a roll reference diameter used in designing a motor for driving or a decelerator does not always conform to the feed diameter that is to be changed by a pipe manufacturing condition and the feed diameter less than the roll reference diameter might act as a brake.

In other words, if a BD stand is responsible for both forming and thrust, stabilization of the thrust is sacrificed. Specifically, it has been found that forming reaction force (= change in thrust) is observed that is generated during operation by pushing and pulling of thrust between BD stands depending on the feed diameter to be changed by a product size and performing roll position management.

Instability of the thrust also affects forming. For example, if a high pressure conforming to the thinnest portion of a coil material is applied in response to thrust shortage, a tug of war of the material between stands may cause meandering of the material or a skid mark on the material.

Furthermore, a forming target metal strip (coil material) does not always have a uniform thickness from top to bottom and a BD roll is under position control management. Hence, if the thickness of the coil is changed, a roll position does not follow this change, thereby changing forming reaction force and also changing thrust. Meanwhile, BD rolls are used for pinching right and left edge portions of the coil in a width direction. Hence, if the rolls are under pressure control, the presence of a difference in thickness between the right and the left of the coil material tilts an upper roll unit even slightly. As a result, no choice except to select position management is left.

Briefly, it has been found that, for realizing automatic operation, even if correction is predicted and the position of a roll is controlled freely and correctly in response to comparison between simulation result about a forming process and positional information about a forming raw material, the analysis on the forming process requires a constant traveling speed of the raw material as a premise and the occurrence of a phenomenon of pushing and pulling of the raw material between breakdown BD1 to BD4 to be driven might result in the failure to ensure required thrust, thereby causing hindrance to fit bending.

On the basis of this founding, earnest consideration has been given on the reproducibility of simulation result about a forming process in terms of both a fit bending method and a forming apparatus employing fit bending.

In order to set a point of pinch using upper and lower rolls correctly and perform forming through fit bending reliably in a breakdown BD section, it is important to allow a raw material to pass through BDs in multiple stages by giving a constant speed and constant thrust to the raw material with a forming roll irrespective of generation of the thrust at the raw material. With a focus on this issue, a driving method has been considered and a focus has been given on the necessity of applying thrust in front of and behind a breakdown roll BD sufficient for passage through the BD.

In this regard, installation of a drive roll stand exclusive to driving has been considered. Then, it has been found that, by employing upper and lower flat rolls with definite roll reference diameters as drive rolls DR, passage through a forming caliber of the breakdown roll BD is realized under application of stable and required thrust at the drive rolls DR arranged in stages in front of and behind the breakdown roll BD.

Consideration has further been given to a method of arranging stands. Then, it has been found that, by arranging the drive rolls DR in stages in front of and behind the breakdown roll BD and using the drive rolls DR exclusively to driving and by using the BD roll stand as a non-drive stand exclusively to forming to apply thrust to a central portion of a material under pressure control at the flat rolls of the DR stand, a definite roll reference diameter is given and the raw material is fed at a constant speed and constant thrust, making it possible to ensure thrust required for various product outer diameters or thicknesses in line with simulation result about a forming process. It has also been found that, performing roll position control correctly at the BD roll stand allows precise passage of the raw material inside a required roll caliber and allows forming at a pinch point and fit bending to be performed reliably to improve forming performance in a BD roll stand group, thereby completing the invention.

The present invention is intended for a manufacturing apparatus for a welded pipe that is a forming mill used in a breakdown step of performing bending from opposite edge portions of a forming target raw material by an edge bending forming system by employing an involute curve partially in an upper roll caliber, using a forming roll for fit bending of bending the raw material in a region external to or internal to a pinch point in a width direction of the raw material where the raw material is pinched with an upper roll and a lower roll while making a fit to the upper roll, and using multi-use forming rolls in multiple stands designed in a roll flower defining roll multi-use within a several-fold range in diameter ratio, wherein
the manufacturing apparatus has a configuration in which non-drive type breakdown rolls BD exclusive to bending are arranged in multiple stands, drive roll DR stands exclusive to driving are arranged in stages in front of and behind each BD stand, and the drive roll DR applies thrust to a central portion of the raw material using an upper flat roll and a lower flat roll, and has thrust control means and driving rotation number control means for applying thrust required for passage through the step using the drive rolls DR in multiple stages entirely and controlling the thrust.

According to the present invention, in the breakdown mill, the thrust control means includes a fluid pressure device for applying load to the upper roll of each drive roll and has load control means.

According to the present invention, in the breakdown mill, the upper and lower flat rolls of the drive roll have shapes conforming to flatness at the central portion of the forming target raw material.

The present invention is further intended for a manufacturing apparatus for a welded pipe wherein a cluster mill with non-drive type four-direction or three-direction multi-use cluster roll stands in multiple stages responsible for forming of a lower portion of the raw pipe by a circular bending system is arranged on a downstream side of the above-described breakdown mill, and a fin-pass mill is arranged on a downstream side of the cluster mill to configure a pipe mill, the fin-pass mill including drive-type fin-pass roll stands in multiple stages for forming into an approximately circular shape in preparation for a squeeze step, wherein
the manufacturing apparatus has thrust distribution control means for distributing thrust required for passage through each step of forming of the forming target raw material into a round pipe to a drive roll group in multiple stages of the breakdown mill and a fin-pass roll group in multiple stages of the fin-pass mill to apply thrust from the drive roll and the fin-pass roll to the forming target raw pipe and control the thrust.

According to the present invention, in the above-described pipe mill, the thrust distribution control means is arithmetic means that operates each of the thrust control means and the driving rotation number control means for the drive roll group, the position control means for controlling the position of the fin-pass roll in the stand, and the driving rotation number control means for the fin-pass roll in line with distribution information about the thrust.

The present invention is intended for a manufacturing method for a welded pipe wherein
in a breakdown step of performing bending from opposite edge portions of a forming target raw material by an edge bending forming system by employing an involute curve partially in an upper roll caliber, using a forming roll for fit bending of bending the raw material in a region external to or internal to a pinch point in a width direction of the raw material where the forming target raw material is pinched with an upper roll and a lower roll while making a fit to the upper roll, and using multi-use forming rolls in multiple stands designed in a roll flower defining roll multi-use within a several-fold range in diameter ratio,
by using a breakdown mill having a configuration in which non-drive type breakdown rolls BD exclusive to bending are arranged in multiple stands, drive roll DR stands exclusive to driving are arranged in stages in front of and behind each DR stand, and the drive roll DR applies thrust to a central portion of the raw material using an upper flat roll and a lower flat roll, and having thrust control means and driving rotation number control means for applying thrust required for passage through the step using the drive rolls DR in multiple stages entirely and controlling the thrust,
on the basis of result of simulation analysis conducted on a forming process of forming from the forming target raw material into a semi-circular pipe in response to a difference in type or dimension within a range of multi-use on the assumption of the breakdown mill having the forming roll stand configuration and to be operated by an identified procedure, thrust information required for edge bending in the breakdown step responsive to the forming target raw material is acquired and thrust is applied to the forming target raw plate using the drive rolls DR entirely.

The present invention is further intended for a manufacturing method for a welded pipe wherein
in a breakdown step of performing bending from opposite edge portions of a forming target raw material by an edge bending forming system by employing an involute curve partially in an upper roll caliber, using a forming roll for fit bending of bending the raw material in a region external to or internal to a pinch point in a width direction of the raw material where the raw material is pinched with an upper roll and a lower roll while making a fit to the upper roll, and using multi-use forming rolls in multiple stands designed in a roll flower defining roll multi-use within a several-fold range in diameter ratio, in a subsequent circular bending step of bending into a circular cylindrical shape through center bending, and in a subsequent fin-pass roll forming step of forming into a required circular shape by fixing end surface shapes at edge portions of the raw pipe intended to form butting contact therebetween,
by using a pipe mill including:
   a breakdown mill having a configuration in which non-drive type breakdown rolls BD exclusive to bending are arranged in multiple stands, drive roll DR stands exclusive to driving are arranged in stages in front of and behind each BD stand, and the drive roll DR applies thrust to a central portion of the raw material using an upper flat roll and a lower flat roll, and having thrust control means and driving rotation number control means for applying thrust required for passage through the steps using the drive rolls DR in multiple stages entirely and controlling the thrust; and
   a cluster mill arranged on a downstream side of the breakdown mill and including non-drive type four-direction or three-direction multi-use cluster roll stands in multiple stages responsible for forming of a lower portion of the raw pipe by a circular bending system, and a fin-pass mill arranged on a downstream side of the cluster mill, including drive-type fin-pass roll stands in multiple stages for forming into an approximately circular shape in preparation for a squeeze step, and having position control means for controlling the position of a fin-pass roll in the stand and driving rotation number control means for the fin-pass roll,
   on the basis of result of simulation analysis conducted on a forming process of forming from the forming target raw material into a circular pipe in response to a difference in type or dimension within a range of multi-use on the assumption of the pipe mill having the forming roll stand configuration and to be operated by an identified procedure, thrust information required for forming in each of the forming steps responsive to the forming target raw material is acquired and thrust is applied to the forming target raw pipe using a stand group of the drive rolls DR and a stand group of the fin-pass rolls FP.

### Advantageous Effects of Invention

As a result of the analysis on the forming process described above, thrust required at the breakdown mill and thrust required at the fin-pass mill are determined to decide driving force to be assigned to each drive roll and each fin-pass roll.

In the breakdown forming section, it is not required to give consideration to driving force to be generated at a forming roll itself but the forming roll can be given an outer diameter or a roll caliber more specialized for forming irrespective of a roll reference diameter for driving. Moreover, an entry resistance received by a raw material during passage through a caliber of such a forming roll can be analyzed, making it becomes possible to grasp thrust in advance required for real forming.

As the drive roll drives the forming target raw plate while pinching a central portion of the raw plate with the upper and lower rolls and applies thrust, resultant thrust information required for forming or pipe manufacturing can be used effectively.

The drive roll is used for acquiring thrust easily as a result of its flat shape and its wide contact area, has a definite roll reference diameter, can be used uniformly in all drive roll stands, and facilitates synchronization between speeds. For example, the roll may be subjected to control of load (pressure) using a hydraulic cylinder to allow generation of constant thrust even if the thickness of the forming target raw material is changed.

As the drive roll has a small roll diameter, a driving torque and a reduction ratio can be reduced and uniform specifications can be employed for a decelerator, maintenance performance of the apparatus is improved and maintenance cost for the apparatus can also be reduced.

As a result of the absence of a drive main shaft at the breakdown stand, design flexibility of the forming stand is increased and a roll diameter can be reduced. This shortens an interval between stands, thereby producing the advantage of improving threading performance of the forming target raw plate.

### Brief Description of Drawings

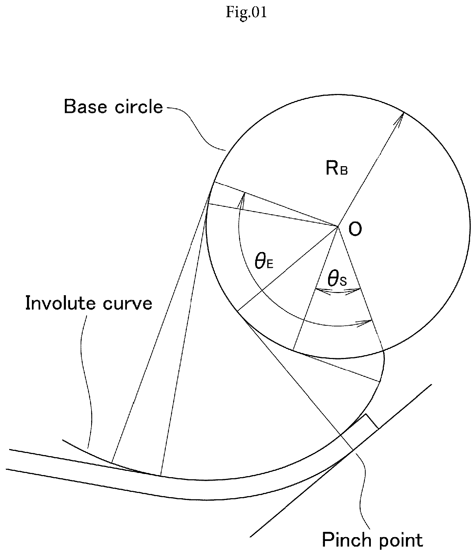

Fig. 1 is an explanatory view showing fit bending and shows an involute caliber employed at a roll surface and a pinch point where a forming target raw plate is pinched with upper and lower rolls. Edge bending is performed by bending the raw material while fitting the raw material to the upper roll external to or internal to the pinch point in a raw material width direction.
Fig. 2A is an explanatory view of a multi-use roll showing breakdown steps BD1 to BD4 in which the forming roll is used as a multi-use roll for performing edge bending, and shows that an interval between rolls is increased or reduced and a roll position is moved up and down relative to the width of a forming target raw material.
Fig. 2B is an explanatory view of a multi-use roll showing circular bending steps CL1 to CL4 in which the forming roll is used as a multi-use roll for forming from a semi-circular shape into an approximately circular shape after implementation of the breakdown steps BD1 to BD4 in which the forming roll is used as a multi-use roll for performing the edge bending, and shows that an interval between rolls is increased or reduced and a roll position is moved up and down relative to the width of the forming target raw material.

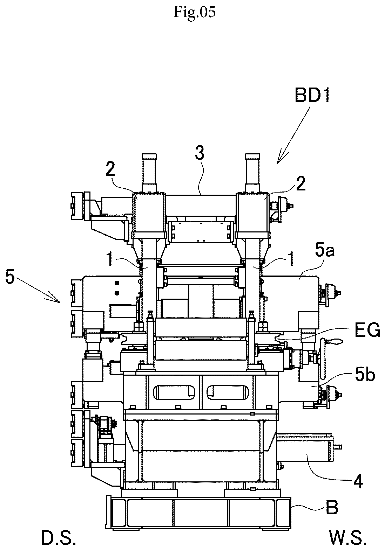

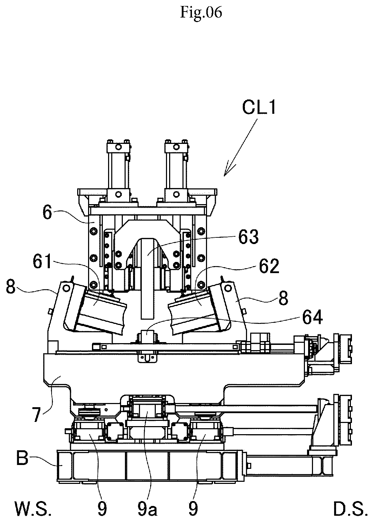

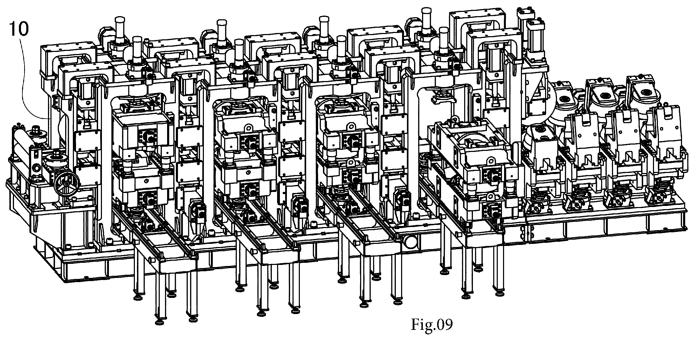

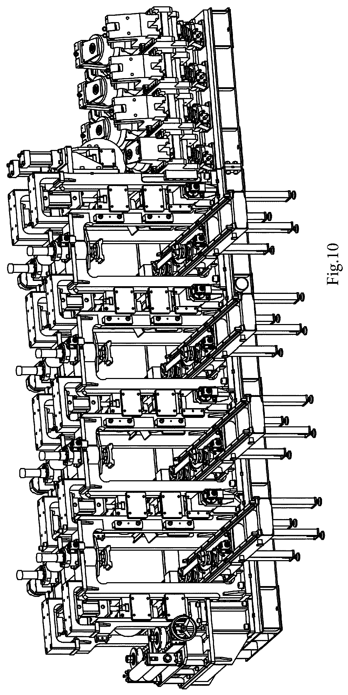

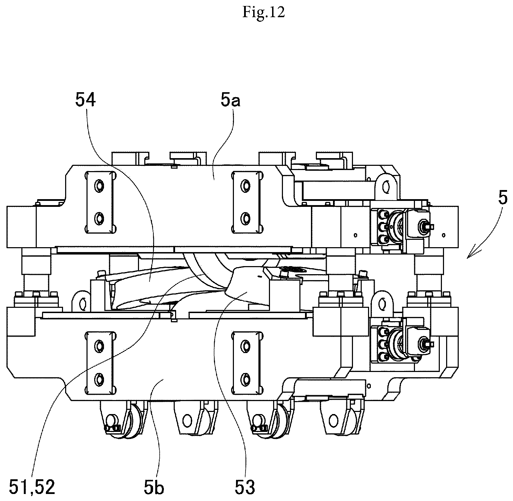

Fig. 3 is a conceptual perspective explanatory view taken panoramically in a pass line direction showing positional correlation between a forming target raw plate and forming rolls obtained from result of simulation analysis on a forming process conducted on a mill having roll stand arrangement similar to that of a breakdown mill and a cluster roll mill according to Example shown in Figs. 4 to 15, a fin-pass mill, and a squeeze mill.
Fig. 4 shows a front explanatory view of the breakdown mill and the cluster roll mill according to Example of the present invention taken from a work side W. S. A forming target raw plate moves from left to right of the drawing.
Fig. 5 is a left side explanatory view of a range to a breakdown roll stand BD1 taken from an upstream side of Fig. 4.
Fig. 6 is a right side explanatory view of a cluster roll stand CL1 taken from a downstream side of Fig. 4.
Fig. 7 is a perspective explanatory view showing a drive roll stand.
Fig. 8 is a perspective explanatory view showing the mills according to Example shown in Fig. 4.
Fig. 9 is a perspective explanatory view of the mills in a state where an extraction rail table is arranged for laterally extracting upper and lower roll units housing upper and lower rolls from the breakdown roll stand toward the work side.
Fig. 10 is a perspective explanatory view of the mills in a state where the upper and lower roll units housing the upper and lower rolls are laterally extracted entirely from the breakdown roll stand and in a state where the extraction rail table for the lateral extraction is arranged on the work side.
Fig. 11A is a perspective explanatory view showing upper and lower roll units of the breakdown roll stand BD1.
Fig. 11B is a perspective explanatory view showing the upper and lower roll units of the breakdown roll stand BD1.
Fig. 12 is a perspective explanatory view showing upper and lower roll units of the breakdown roll stand BD4.
Fig. 13 is a perspective explanatory view of an upper frame body housing an upper roll of the breakdown roll stand BD2.
Fig. 14 is a perspective explanatory view of a lower frame body housing a lower roll of the breakdown roll stand BD2.
Fig. 15 is a perspective explanatory view of a lower frame housing a lower roll of the breakdown roll stand BD4.

### Embodiments for Carrying Out Invention

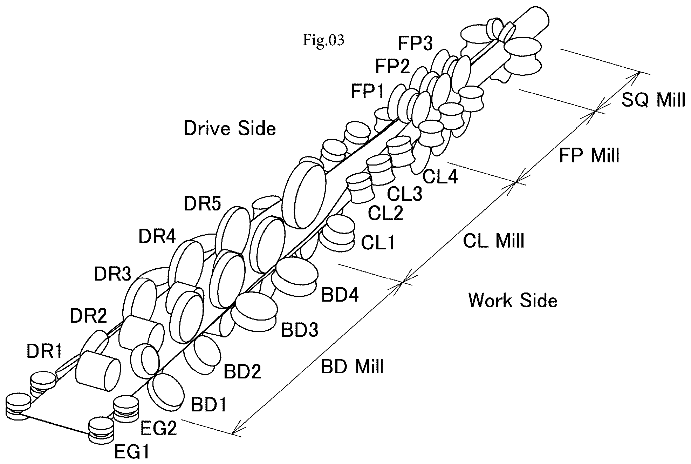

On the basis of a conceptual perspective explanatory view in Fig. 3 taken panoramically in a pass line direction showing positional correlation between a forming target raw plate and forming rolls obtained from result of simulation analysis conducted on a pipe mill including roll stands arranged in the same manner as in a breakdown mill according to Example, a process of forming from a plate shape into a round pipe and a roll configuration will be described.

A breakdown mill corresponding to a section of edge bending is composed of breakdown rolls BD1 to BD4 in four stages exclusive to forming. The mill has a configuration in which drive rolls DR1 to DR5 in five stages exclusive to driving are arranged in front of and behind the breakdown rolls in four stages so the stands DR1, BD1, DR2, BD2, DR3, BD3, DR4, BD4, and DR5 are arranged in this order.

While the breakdown mill is composed of a non-drive type roll group exclusive to forming in which multi-use is encouraged within a several-fold range in diameter ratio, the breakdown mill can basically be said to be a structure with a drive-type drive roll group provided inside the mill in which a forming target raw plate is pinched at a central portion with upper and lower flat rolls to apply thrust.

A cluster mill corresponding to a next section of circular bending of forming into a semi-circular shape includes cluster rolls CL1 to CL4 arranged in four stages. The cluster roll is composed of a non-drive type roll group exclusive to forming encouraging multi-use.

Here, a fin-pass roll section for further forming into a circular shape is composed of a fin-pass roll mill including drive-type four-direction fin-pass rolls FP1 to FP3 arranged in three stages.

Each of the fin-pass roll stands FP1, FP2, and FP3 is composed of an upper roll with a fin roll for fixing end surface shapes at edge portions of a raw material intended to form butting contact therebetween, and a side roll and a lower roll for forming into a required round pipe shape. Here, both bending and squeezing are performed in this section.

In the case of a two-direction fin-pass roll, this fin-pass roll has upper and lower rolls divided into two, and the upper roll has a fin roll.

A final squeeze section is composed of a non-drive type squeeze roll stand SQ in one stage and performs welding while making a butt between the edge end surfaces.

A forming process of forming a metal strip into a metal pipe using a predetermined forming roll in a pipe mill having the above-described configuration is analyzed by conducting simulation analysis on elastoplastic deformation based on a roll flower defined in advance.

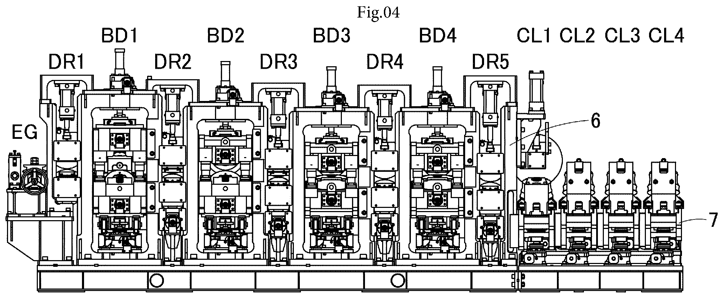

As shown in a conceptual perspective explanatory view of simulation analysis result shown in Fig. 4, using a metal strip of a certain dimension and a certain material as a target, a forming process is analyzed as correlation between a deformed shape state of the raw material deformed from the metal strip to the metal pipe using all forming rolls in the pipe mill except an entry guide EG and a drive roll DR and positioning of a forming roll contacting the raw material.

In conducting analysis using three-dimensional CAD data and a three-dimensional elastoplastic FEM analysis method, on the assumption that a roll is not driven to rotate but the forming target raw material itself moves at a constant speed, it is possible to grasp forming reaction forces and entry resistances received at all forming rolls in a forming process of elastoplastically deforming the forming target raw material during which the forming target raw material goes into a caliber composed of various forming rolls and receives an entry resistance, for example.

Thus, during the analysis, while no consideration is given to the presence of the drive rolls DR1 to DR5 in the breakdown forming section and the fin-pass rolls FP1 to FP3 are not driven to rotate in the fin-pass forming section, forming reaction force and a resistance of entry into a caliber received by a roll are grasped in any forming section relating to forming of elastoplastically deforming the forming target raw material.

As a result, forming load and required thrust are determined for each forming roll stand and thrust required for passage through each forming section can also be calculated. Furthermore, a forming process is analyzed in response to each difference in product dimension or material, making it possible to calculate thrust to be applied to each type of forming target raw material.

In the perspective explanatory view taken panoramically in a traveling direction of the forming target raw material, thrust is applied to the forming target raw pipe by the drive rolls DR1 to DR5 in five stages and the fin-pass rolls FP1 to FP3 in three stages in a forming process of forming from a plate-shape into a round pipe.

As a result of the above-described analysis on the forming process, thrust required for passage through steps to a squeeze step of welding into the round pipe is grasped and thrust required in the breakdown mill and the fin-pass mill is determined, making it possible to decide driving force to be assigned to each drive roll and each fin-pass roll.

In the breakdown forming section, it is not required to give consideration to driving force to be generated at a forming roll itself but analysis can be conducted on an entry resistance received by a raw material during passage through a caliber defined by using a forming roll configured by employing an outer diameter or a roll caliber more specialized for forming irrespective of a roll reference diameter for driving. Thus, it possible to grasp thrust in advance required for real forming.

As the drive roll drives the forming target raw plate while pinching a central portion of the raw plate in a width direction with upper and lower rolls and applies thrust, resultant thrust information required for forming or pipe manufacturing is used effectively.

The drive roll is used for acquiring thrust easily as a result of its flat shape and its wide contact area, has a definite roll reference diameter, and can be used uniformly in all drive stands, thereby facilitating synchronization between speeds. For example, the roll can be subjected to control of load (pressure) using a hydraulic cylinder to allow generation of constant thrust even if the thickness of the forming target raw material is changed.

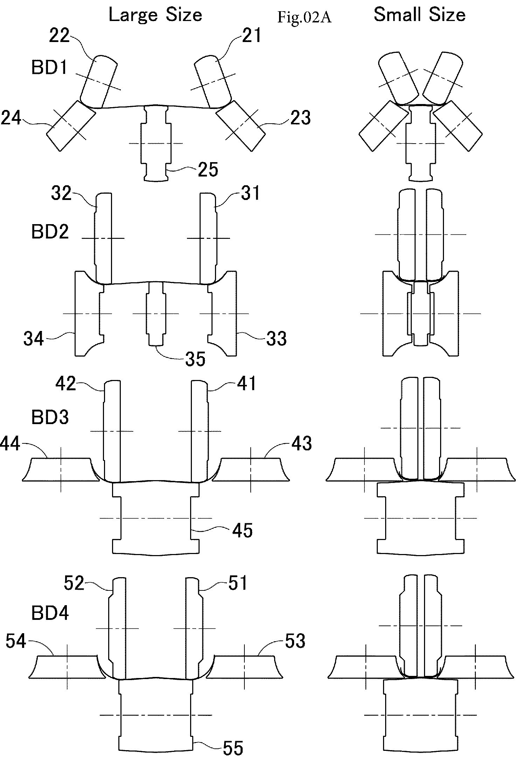

A flat roll is basically used as the drive roll. A central portion of a forming target raw material in a width direction pinched with the breakdown rolls shown in Fig. 2A is slightly lifted with the lower roll. This is intended to facilitate fit bending in the vicinities of opposite edge portions of the raw material. In this regard, the upper and lower flat rolls of each of the drive roll DR2 to DR4 can be formed into shapes conforming to flatness at the central portion of the forming target raw material. In this case, the operation and effect described above are the same.

As the drive roll has a small roll diameter, a driving torque and a reduction ratio can be reduced and uniform specifications can be employed for a decelerator, maintenance performance of the apparatus is improved and maintenance cost for the apparatus can also be reduced.

As a result of the absence of a drive main shaft at the breakdown stand, design flexibility of the forming stand is increased and a roll diameter can be reduced. This shortens an interval between stands, thereby producing the advantage of improving threading performance of the forming target raw plate.

Any publicly-known method of carrying a metal strip using a roll can be employed as thrust control means for applying thrust required for passage through a breakdown step and controlling the thrust using the drive rolls DR in multiple stages entirely. If an electric motor is used for driving, for example, an employable method is a method of directing a required rotation number using driving rotation number control means for the electric motor and then controlling thrust through adjustment of the positions of upper and lower rolls, or a method of adjusting thrust by adjusting the position of the lower roll and then adjusting the position of the upper roll as appropriate. A publicly-known mechanical mechanism is employable for adjusting the positions of the upper and lower rolls.

Further provided is a fluid pressure device, a pneumatic cylinder, or a hydraulic cylinder, for example, for applying load to the upper roll after adjustment of the positions of the upper and lower rolls. A valve may be operated so as to generate a required pressure at each fluid pressure device, and a PLC, a microcontroller, or a computer may be used for directing such operation.

A manufacturing apparatus and a manufacturing method of the present invention are characterized in that, in manufacturing a metal pipe, thrust information required for forming of a forming target raw material from a plate-like shape into a round pipe is acquired on the basis of analysis result about a forming process in each step of the forming, thrust required for passage through each step is distributed to a drive roll group in multiple stages of the breakdown mill and a fin-pass roll group in multiple stages of the fin-pass mill, and the thrust is applied to the forming target raw material and controlled using the drive roll and the fin-pass roll.

Thrust distribution control means is required to include thrust control means and driving rotation number control means for the drive roll group, position control means for position control of a fin-pass roll in a stand, and driving rotation number control means for the fin-pass roll.

In particular, each of the above-described fin-pass rolls FP1 to FP3 in three stages is not a multi-use roll but is a four-direction roll with an upper roll, a side roll, and a lower roll including a fin roll that is to be changed to a roll responsive to a product dimension. Thus, this fin-pass roll is to contact an entire periphery of a forming target raw pipe and is used optimally for application of thrust. Control of position adjustment of each roll and adjustment of driving force of the roll that may be control of a driving rotation number, for example, becomes significant in controlling forming performance and application of thrust.

Specifically, a roll responsive to a product dimension is used as a changed roll and forming into a required round pipe shape is realized while end surface shapes at edge portions intended to form butting contact therebetween. Thus, control may be performed in such a manner that a roll position is adjusted in a stand using a position adjustment mechanism such as a jack connected to a roll axial support, for example, to apply predetermined pressurizing force and set thrust, and a predetermined number of rotations is maintained at a driving motor for a roll to generate predetermined thrust at the fin-pass rolls in three stages.

On the basis of thrust information required for pipe manufacturing, distribution of thrust to the drive roll group and the fin-pass group required for passage through each step can be set by operating the PLC or the microcontroller for controlling a jack or an electric motor for each stand. If a difference in a distribution method occurs as a result of a difference in product dimension or a difference in type, however, it is desirable to perform thrust distribution control using all PLCs or microcontrollers for corresponding stands or using an arithmetic device for controlling each forming section with the aim of facilitating operation or performing the operation automatically.

For example, an arithmetic device usable in performing the thrust distribution control using the arithmetic device includes a storage core unit that calculates and stores distribution of thrust to the drive roll group and the fin-pass roll group, a core unit that controls a driving rotation number of each drive roll, a direction core unit that gives a direction to generate required load at a fluid pressure device to apply load to the upper roll of the drive roll, a position control core unit that performs position control of the fin-pass roll in each stand, and a power control core unit that controls a driving rotation number of the fin-pass roll.

To operate the pipe mill automatically, the following operations are performed in advance.

A forming process assumed in this mill is analyzed for each of metal strips of various dimensions (plate widths, thicknesses) in a range of multi-use of a forming roll or each of various types of metal strips of respective dimensions or qualities based on differences in the dimensions, materials or purposes of use of the metal strips, or types thereof such as specifications.

A forming process defined by using a roll flower is based on the assumption that a raw pipe is in a state directly under a forming roll. However, a deformed shape value of the raw pipe directly under the forming roll is not measurable. A deformed shape value of the raw pipe is at least one of an outer peripheral surface shape, an inner peripheral surface shape, a vertical sectional shape, an outer peripheral length, and forming load at each stand in a forming roll stand array.

On the basis of result of the analysis on the various types of forming processes described above, it is possible to acquire a deformed shape value of a raw pipe in the vicinity of each of all forming roll stands that may be on an upstream side or a downstream side of a position immediately near the stand, for example, or a deformed shape value of the raw pipe in the vicinity of a forming tool such as a forming caliber in each stand, and positional information about a forming roll in each stand.

The analysis result about these various forming processes can be assumed as data about each metal strip having the assumed certain dimension and quality described above, namely, data about a correlation value according to a certain ideal model relating to a certain type of metal strip between a deformed shape value of a raw pipe and the position of a forming roll.

In another case, in a forming roll stand in a certain range or at a particular position along a pass line of the pipe mill, such analysis result can also be regarded as data about a correlation value between a deformed shape value of a raw pipe in the vicinity of the stand or in the vicinity of the forming roll and positional information about a forming tool in the particular stand.

An analysis method to be employed for analyzing a forming process during the course of forming a certain metal strip into a metal pipe using a certain forming roll may be simulation analysis that is conducted using various types of publicly-known analysis methods on the basis of a roll flower and roll surface shape design assumed to be employed at the time of design. For example, CAE analysis is used for mechanical design and a finite element method is indispensable. Preparation of a model and shape simplification for the method are required. An analysis method using 3D CAD and a combination of shape data and various types of analysis methods can also be employed. Moreover, three-dimensional elastoplastic FEM analysis may be employed additionally for the analysis. The analysis can be conducted on the basis of each forming roll stand or on the basis of each forming section.

As a result of the foregoing simulation analysis, it becomes possible to acquire analysis result about a variety of forming processes as data about correlation values between deformed shape values of a wide range of raw pipes and a forming tool position.

The foregoing analysis result may simply be used as numerical value data for further analysis. However, in order to allow recognition by a human or artificial intelligence in making comparison between such correlation value data according to a certain ideal model in a certain pipe mill and correlation value data resulting from measurement using a real operation model at the same mill, it is desirable to define and employ a program for providing the correlation value data as visualized data for allowing conversion into positional information on particular coordinates, for example, and also for allowing conversion into a two-dimensional or three-dimensional image.

By giving consideration to a raw pipe shape measurable using a measurement sensor at the pipe mill during real operation, a deformed shape value of a raw pipe may be any one of an outer peripheral surface shape, an inner peripheral surface shape, a vertical sectional shape, an outer peripheral length, and forming load at each stand in a forming roll stand array. In another case, these elements may be combined in various ways to provide the deformed shape value as visualized data.

For example, a deformed shape value of a raw pipe to be used may be a value obtained through conversion into a numerical value, visualization or conversion into an image on coordinates or in virtual space of any one of an outer peripheral surface shape, an inner peripheral surface shape, and a vertical sectional shape, or all of these shapes defined by opposite edge positions and a width dimension of the raw pipe defined in a direction horizontally perpendicular to a line center plane as a vertical plane including a pass line corresponding to a traveling direction of the raw pipe set in advance, and a height of the raw pipe observed on the line center plane.

A measurement sensor to be employed appropriately for allowing measurement of a deformed shape value of a raw pipe being formed during each of steps including pipe manufacturing, welding, and shaping may be a publicly-known measurement method such as mechanical measurement or magnetic measurement using various types of contacts or proximity elements, non-contact optical scanning using a laser beam, a camera, etc. in combination, or non-contact magnetic scanning.

Any of the above-described publicly-known methods can be employed as a method for measuring the opposite edge positions and the width dimension of the raw pipe defined in the direction horizontally perpendicular to the line center plane as a vertical plane including the pass line corresponding to the traveling direction of the raw pipe set in advance, and the height of the raw pipe observed on the line center plane described above. For measurement of forming load at each stand, any type of publicly-known load sensor is available such as a load cell for measuring load on a roll axis, for example.

For pipe manufacturing, in order to prevent a scar or dirt to be caused by scale removed by bending, a water-soluble lubricant is used like in the case of hot-rolled steel. This water-soluble lubricant is injected or sprayed onto a raw pipe or a roll at a required roll stand. Hence, in an atmosphere of injecting or spraying such a solvent in large quantity, the raw pipe may be covered or wet with the water-soluble lubricant, etc., making it impossible or difficult to measure a deformed shape value of the raw pipe.

This may be handled, for example, by using a metal strip de-scaled in advance through a chemical de-scaling process such as pickling or a mechanical de-scaling process performed in an off-line place. Furthermore, pipe manufacturing may be started after performing a mechanical de-scaling process on any of an entire surface, an outer peripheral intended surface, and an inner peripheral intended surface, or part of these surfaces of a metal strip as a raw material before forming.

During such a pipe manufacturing step, it is desirable to perform partial lubrication of spraying a small quantity of a water-insoluble lubricant onto a required portion of a metal strip or a forming tool in response to need without using a water-soluble lubricant.

Automatic operation can be performed using the pipe mill of the present invention. A method employed herein is such that, by using arithmetic means that makes comparison with data in storage means and predicts a forming process for a raw pipe on the basis of a deformed shape value of the raw pipe being formed that is measured together with information about the dimension or type of the forming target raw material through a step of measuring a deformed shape value of the raw pipe being formed using a measurement sensor during implementation of a step on an analysis target, the method assumes a forming process unique to the raw pipe during implementation of the step on the analysis target, selects forming roll positional information required for implementation of the assumed forming process, and outputs positional information about a forming roll in a stand required to be adjusted.

### Example

The pipe mill shown in Fig. 4 has a configuration in which and entry guide EG on an entry side, breakdown roll stands BD1 to BD4 in four stages, and cluster roll stands CL1 to CL4 in four stages are all coupled and integrated with each other. All the stands are mounted on a common base B and are connected to each other.

A near side of a line direction in which a forming target raw material travels from left to right of the drawing is called a work side W. S., and a far side of the direction is called a drive side D. S.

The breakdown roll stand includes a gate-type frame 1 with heads of columns in a pair connected to each other by a beam member and arranged in a standing position in the line direction on each of the work side and the drive side. A work side and a drive side at the same position of the beam member on which up-and-down jacks 2 are mounted are connected to each other via a crossbeam 3, and a box-shaped up-and-down screw jack unit 4 for upward and downward movement of a lower roll is fixedly arranged between the work side and the drive side at a lower portion of the gate-type frame 1.

An upper and lower roll unit 5 is arranged in such a manner that the upper and lower roll unit 5 can be inserted and extracted in a horizontal direction from the work side to the drive side. The upper and lower roll unit 5 has a box shape with a stack including an upper frame body 5a with built-in upper rolls in a pair movable for extension and contraction in a raw material width direction, and a lower frame body 5b with built-in lower rolls in a pair arranged across a lower center roll and movable for extension and contraction. Inserting the upper and lower roll unit 5 into the gate-type frame 1 connects the up-and-down jacks 2 at the frame tops to the upper frame body 5a and mounts the lower frame body 5b fixedly on the up-and-down screw jack unit 4.

A drive roll stand is not an independent stand. The upstream-side drive roll stand DR1 has a configuration in which roll chocks 11a, 12a of upper and lower flat rolls 11, 12 are caught and supported by a column 10 and the gate-type frame 1 of the breakdown roll stand BD1. A bridge member 14 with a suspended hydraulic unit 13 is connected between the respective tops of the column 10 and the gate-type frame 1 of the breakdown stand BD1 to make the upper roll chock 11a movable up and down. The lower roll chock 12a is fixedly mounted on an up-and-down wedge unit 15.

Each of the drive roll stands DR2, DR3, and DR4 has a configuration for housing by sharing the gate-type frame 1 on an upstream side and the gate-type frame 1 on a downstream side of the drive roll stand. The roll chocks 11a, 12a of the upper and lower flat rolls 11, 12 are caught and supported using the gate-type frames 1. The bridge member 14 with the suspended hydraulic unit 13 for moving the upper flat roll chock 11a up and down is fixed to the top of the gate-type frame 1.

Like the upstream-side drive roll stand DR1, the downstream-side drive roll stand DR5 has a configuration for housing by sharing the stand BD4 and a columnar frame 6 of the cluster roll stand CL1.

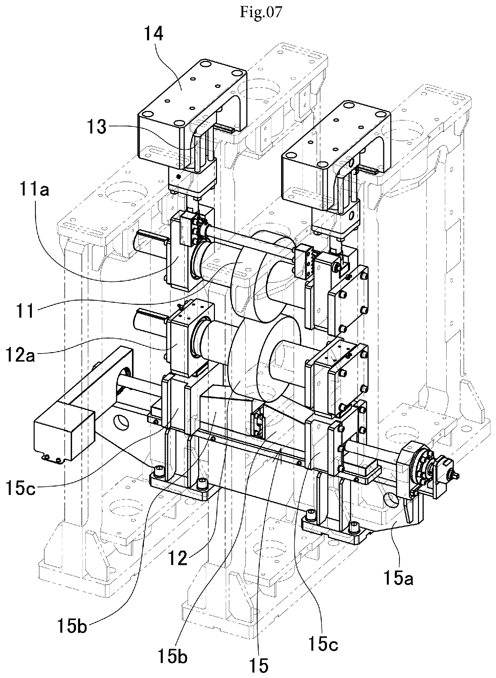

The configuration of the up-and-down wedge unit 15 is described by referring to Fig. 7. By moving wedge members 15b, 15b in a pair having tilting surfaces lifting toward the center on a beam member 15a using a traveling nut mechanism in such a manner as to move the wedge members 15b, 15b closer to or farther from each other, up-and-down members 15c, 15c are raised onto the tilting surfaces and the roll chock 12a (the lower frame body 5b in the BD) is fixedly mounted on the up-and-down members 15c, 15c.

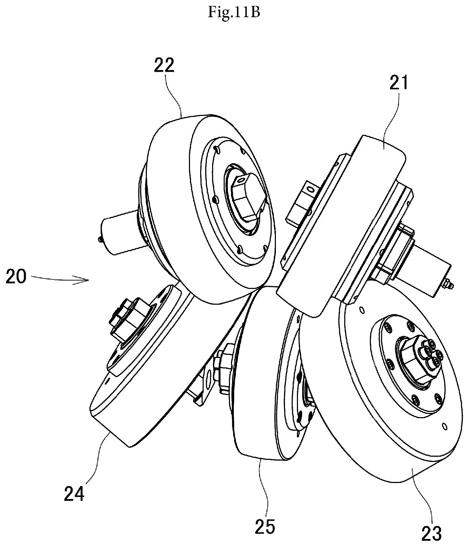

As shown in Fig. 11B, an upper and lower roll 20 of the breakdown roll stand BD1 in the first stage is composed of upper rolls 21, 22 (top rolls) in a pair having a swinging roll function of changing a position of abutting contact with a raw plate, lower rolls 23, 24 (side rolls) for pinching the vicinities of opposite edge portions of the raw plate and performing fit bending together with the upper rolls 21, 22, and a lower center roll 25 (center roll) arranged between the lower rolls 23, 24 in a pair and used for lifting a central portion of the raw plate. Lifting the central portion of the raw plate is intended to facilitate fit bending in the vicinities of the opposite edge portions of the raw plate.

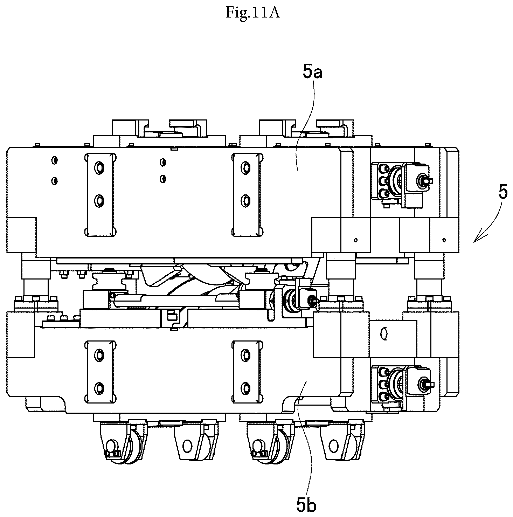

While Fig. 11A does not show the interior of the upper frame body 5a, a configuration inside the upper frame body 5a is such that extension/contraction yokes in a pair slidable in a direction at a right angle to the line are housed, a bearing box of the upper roll is provided in a swinging yoke and is held in a swingable manner by the extension/contraction yokes, the extension/contraction yokes are moved for extension and contraction in a raw material width direction with a screw shaft 5c operated from the drive side, and a warm wheel at a swinging seat is in meshing engagement with a warm shaft operated from the drive side to swing.

The lower center roll is provided in the lower frame body 5b at a central portion thereof, brackets in a pair slidable in the width direction of the forming target raw material are housed on opposite sides of the lower center roll, and the lower rolls are axially supported in tilted positions inside the extension/contraction yokes and are moved for extension and contraction in a direction at a right angle to the line with the screw shaft 5c operated from the drive side.

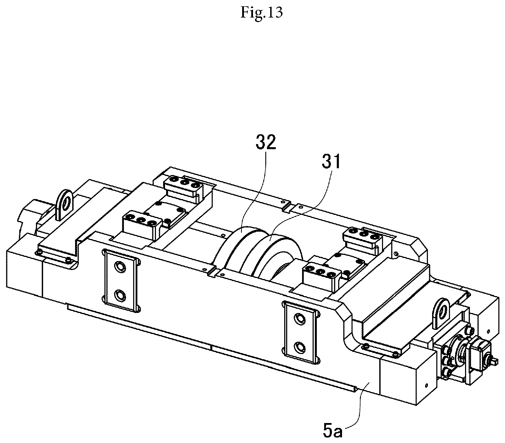

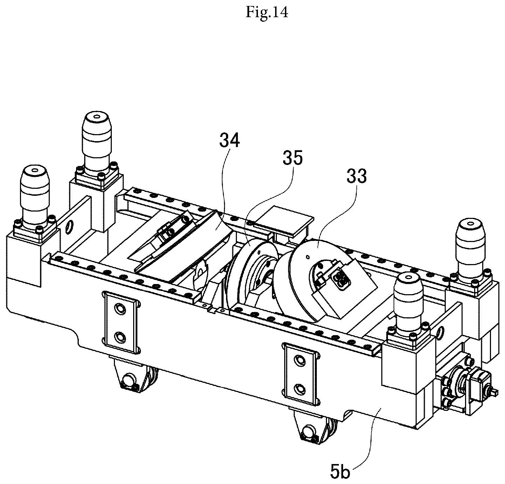

As shown in Figs. 13 and 14, the breakdown roll stand BD2 in the second stage is composed of upper rolls 31, 32 in a pair for forming of a portion internal to the opposite edge portions formed by BD1, lower rolls 33, 34 in a pair for pinching the raw plate together with the upper rolls 31, 32, and a lower center roll 35 arranged between the lower rolls 33, 34 in a pair and used for lifting a central portion of the raw plate. An upper frame body and a lower frame body for housing these upper and lower rolls have configurations same as those in the first stage.

The breakdown roll stands BD3 and BD4 in the third stage and the fourth stage respectively each include side rolls 53 and 54 in a pair having the function of controlling fit bending along upper rolls 51, 52 for forming of a portion still internal to the previously formed edge portions while abutting on and supporting the edge portions bent in the previous two stages, and a wide lower center roll 55 for pinching the raw plate together with the upper rolls 53 and 54.

In the upper frame body 5a, the upper rolls 51 and 52 in a pair are moved for extension and contraction so as to get closer to and farther from each other in the width direction of the raw material using a traveling nut mechanism and a screw shaft operated from the drive side. The upper rolls 51 and 52 are axially supported on nut members arranged coaxially with the screw shaft 5c.

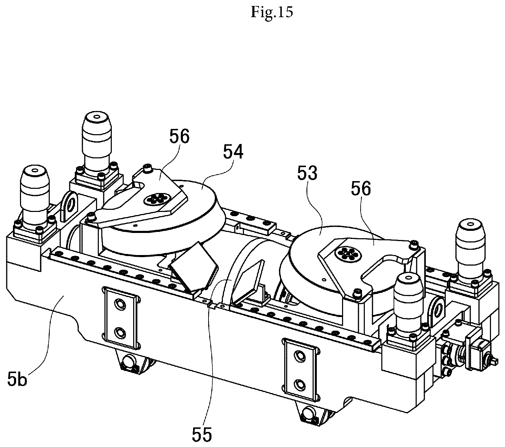

As shown in Fig. 15, also in the lower frame body 5b, the side rolls 53, 54 in a pair are moved closer to and farther from each other (moved for extension and contraction) in the width direction of the raw material using a traveling nut mechanism and a screw shaft operated from the drive side. The lower roll 55 is axially supported at a central portion of the lower frame body and has the built-in screw shaft 5c. Axially-support brackets 56 of the side rolls 53 and 54 are mounted on the nut members arranged coaxially with the screw shaft 5c.

A circular bending section for intermediate forming is provided after the breakdown BD section. The circular bending section is composed of cluster roll stands CL1 to CL4 in four stages.

The cluster roll stand CL1 in the first stage includes built-in cluster side rolls 61, 62 in a pair to abut on edge-bent portions and curved portions internal to the edge-bent portions of the raw plate, and built-in upper and lower center bending rolls 63, 64 for curving (center-bending) a central portion of the raw plate.

The cluster roll stand CL2 in the second stage includes side rolls 71, 72 in a pair for developing bending further at a lower portion of the raw pipe while abutting on the edge-bent portions and the curved portions internal to the edge-bent portions of the raw plate.

The cluster roll stands CL3 and CL4 in the third stage and the fourth stage are composed of side rolls 81, 82 in a pair and side rolls 91, 92 in a pair respectively and a lower roll 83 and a lower roll 93 respectively for rounding of a central portion of the raw plate. The raw plate is formed into an approximately round pipe in the fourth stage.

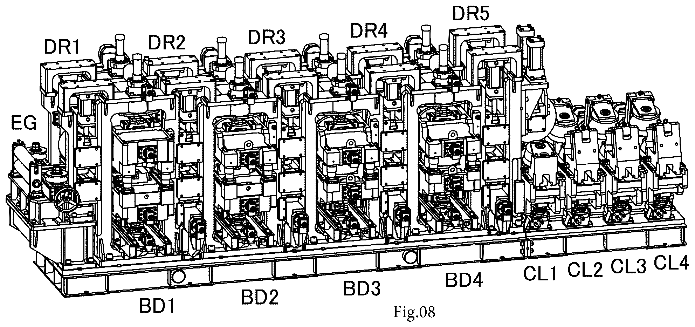

As shown in Figs. 4 and 8, the configuration of the cluster roll stands in four stages is such that a gate-type frame 6 is arranged in a standing position on each of the work side and the drive side, and crossbeam stands 7 provided for the four stages and the near-side stands are supported on each other in such a manner as to allow upward and downward movement.

The lower roll 64 is provided in such a manner as to be movable up and down in a central portion of the crossbeam stand 7 stretched between the work side and the drive side of each stand. Bracket members 8, 8 axially supporting the cluster side rolls 61, 62 are slidably mounted on the crossbeam stand 7 on opposite sides of the lower roll 64. The side rolls 61, 62 in a pair are moved closer to and farther from each other (moved for extension and contraction) in the width direction of the raw material using a traveling nut mechanism and a screw shaft operated from the drive side.

Each crossbeam stand 7 is moved up and down to be located at a position by jacks 9,9 in a pair mounted on the base B below the crossbeam stand 7. The lower roll 64 is individually moved up and down to be located at a position by a different jack 9a.

The cluster roll stand CL1 in the first stage includes a unit in the gate-type frame 6 in which an axis chock of the upper roll 62 is movable up and down using a hydraulic cylinder.

The initial forming section and the intermediate forming section described above are always used for multiple usages within an intended diameter range and are not to be changed. As shown in Figs. 2A to 2B, contact with the raw plate and forming of the raw plate are realized by making swinging motion, horizontal movement in a plate width direction, and vertical movement in the top-bottom direction of the upper roll, horizontal movement of the lower roll in a direction at a right angle to the line, horizontal movement of the side roll in the direction at a right angle to the line, and vertical movement of the center roll in the top-bottom direction relative to the raw plate.

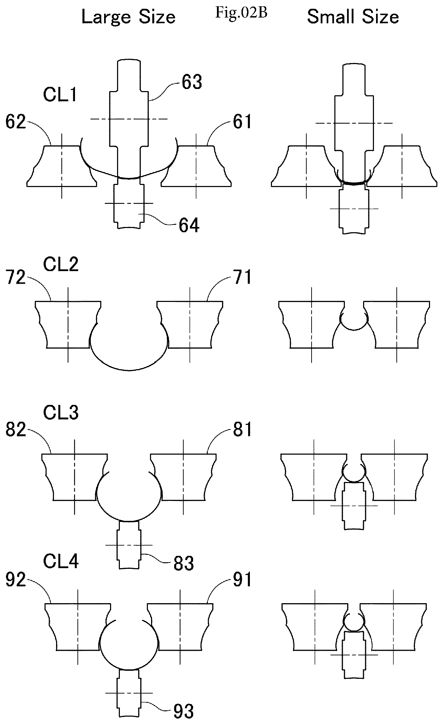

Thus, each forming roll is to move to various positions in a stand. Fig. 2A shows the position of each forming roll during forming with a maximum diameter (maximum plate width) in an intended diameter range. Fig. 2B shows a roll position during forming with a minimum diameter (minimum plate width) in the intended diameter range.

Note that while the breakdown rolls shown in the drawings are conventional rolls on the assumption that these rolls are to be driven, the rolls of Example not to be driven are entirely reduced in diameter and the lower roll and the side roll are tilted for reducing the diameter of the upper roll.

In Fig. 2 showing a difference in position of a multi-use forming roll resulting from a difference in the above-described product dimension, assuming that there are 13 different outer diameter dimensions and 12 different plate thickness dimensions, 156 different sizes are produced. Even if a dimension of an extremely small diameter and an extremely large thickness and a dimension of an extremely large diameter and an extremely small thickness are excluded as they are not available for forming , at least a hundred and several tens of forming roll positions are provided.

A latter forming section is composed of fin-pass roll stands FP1, FP2, and FP3 in three stages, and a squeeze roll stand SQ.

The fin-pass roll stands FP1, FP2, and FP3 are each composed of an upper roll including a fin roll for fixing end surface shapes at edge portions of a raw pipe intended to form butting contact therebetween, and a side roll and a lower roll for forming into a required round pipe shape. Here, both bending and squeezing are mixedly performed. A sectional shape and an edge end surface shape of the raw pipe are fixed to provide shape finishing into a state suitable for welding. Thus, for forming into a different product dimension, change is made to a forming roll responsive to the product dimension.

While the stand configuration of Example is not shown in the drawings, the roll configuration shown in Fig. 3 is used. Furthermore, an upper roll, a side roll, and a lower roll are arranged in frame bodies in a configuration same as that of the breakdown roll stand. These frame bodies are stacked to be capable of being extracted laterally toward the work side.

A jack for moving an upper roll up and down, a jack for moving a side roll horizontally, and a jack for moving a lower roll up and down are arranged in a fin-pass roll stand frame.

Using a pipe mill having the above-described forming roll configuration as a target, a forming process of forming from a metal strip into a metal pipe using the forming roll is analyzed using three-dimensional CAD data and a three-dimensional elastoplastic FEM analysis method. Specifically, using arrangement of forming rolls based on a roll flower set in advance and using a simulation analysis method for analyzing three-dimensional elastoplastic deformation of a metal strip resulting from use of an intended caliber shape, which is, in this case, a simulation analysis method using various types of analysis technique software unique to the inventors incorporated into three-dimensional elastoplastic deformation analysis software developed by the inventors on the basis of a publicly-known three-dimensional elastoplastic deformation analysis method, a stepwise and continuous forming process of forming from a metal strip into a metal pipe using the forming rolls in the corresponding stands in the 12 stages was analyzed for each of the above-described forming steps and was analyzed as a forming process of forming from the plate into the pipe generating elastoplastic deformation of a continuous and integrated object. The forming process was analyzed as correlation between a deformed shape state of the raw pipe deformed from the metal strip to the metal pipe using all the forming rolls in the pipe mill and positioning of a forming roll contacting the raw pipe.

On the basis of result of the analysis, forming load applied to each forming roll, a value of an entry resistance received by a material, and thrust required for passage through each forming section were calculated. A forming process was analyzed in response to each difference in product dimension or steel type to calculate thrust to be applied to various types of forming target raw plates.

As a result, thrust required at the breakdown mill and thrust required at the fin-pass mill were determined to decide driving force to be assigned to each drive roll and each fin-pass roll.

By performing load (pressure) control using an up-and-down hydraulic cylinder, constant thrust could be generated at each drive roll.

In the above-described breakdown mill, the drive roll has a uniform and reduced outer diameter. The BD roll as a roll exclusive to forming is also reduced in diameter. Furthermore, all the stands are connected to each other to be integrated by a unit in which frames are aligned in the pass line direction and the rolls are provided therein in a direction crossing the pass line direction, thereby achieving excellent rigidity and realizing size reduction and weight reduction optimally.

In comparison to the conventional configuration in which a forming roll further functions as a drive roll, in the case of a 5-inch mill of a product diameter from 42.7 to 127 mm, the breakdown roll mill with the built-in drive roll was reduced by 19% in a length in the line direction, by 23% in a width direction, by 14% in a height direction, and by 42% in a stand total weight without rolls.

Not driving the breakdown roll made it possible to reduce the diameters of the upper and lower rolls, to arrange the lower roll or the side roll in a tilted position, to realize layout of various types of upper and lower rolls by arranging the upper roll in the upper frame body and arranging the lower roll in the lower frame body, and to stack the upper and lower frame bodies to allow the upper and lower frame bodies to be extracted laterally in the horizontal direction. The maintenance period such as roll changing or centering can be shortened and cleaning of a roll or a machine can be done easily. Additionally, by preparing a roll unit of a difference range of multi-use and making a change to this roll unit, it becomes possible to expand a manufacturing range.

By arranging the upper and lower rolls of the breakdown roll in the respective frame bodies and using the screw shaft as a moving mechanism for extension and contraction for the rolls, load turns to internal stress. By measuring a vertical component of forming load generated at the frame bodies entirely using a load cell, for example, the measured component can be used as a new parameter for evaluation of the forming load generated at the breakdown roll stand.

In the above-described manufacturing apparatus, thrust information required for forming of a forming target raw material from a plate-like shape into a round pipe is acquired in advance on the basis of analysis result about a forming process in each step of the forming, and thrust required for passage through each step is distributed to the drive roll group in multiple stages of the breakdown mill and the fin-pass roll group in multiple stages of the fin-pass mill. In the case of a thin and small-diameter pipe within a range of multi-use, thrust may be distributed uniformly to the drive roll group and the fin-pass roll group. In the case of a thick and large-diameter pipe within the range of multi-use, thrust may be distributed to the drive roll group and the fin-pass roll group at a ratio of 3:7. For this reason, an electric motor to be used was set so as to achieve conformity of a variable output range of the electric motor with such a range of distribution.

At the stands of the fin-pass rolls FP1 to FP3 in three stages, control was performed in such a manner that a roll position is adjusted in the stand using the roll position adjustment mechanism realized by the jack to apply predetermined pressurizing force and set thrust, and an inverter motor is used as a driving motor for the roll and setting for maintaining a predetermined number of rotations is made to generate thrust stably at the fin-pass roll group in three stages.

### Industrial Applicability

In conducting breakdown forming of forming a metal strip from a plate into a semi-circular shape continuously using a forming roll available for multi-use within a several-fold range in diameter ratio, with a focus on thrust to be applied to a forming target raw material, the breakdown roll responsible for forming and the drive roll to apply thrust are set separately in terms of function according to the method of manufacturing a welded pipe of the present invention. By doing so, it is possible to provide the apparatus for manufacturing a welded pipe of the present invention that allows thrust required for the forming to be applied reliably to the forming target raw material in response to a difference in product dimension or a difference in metal type and achieves forming with high efficiency and high accuracy without causing pushing and pulling of the material in the line direction between the forming roll stands.

### Reference Signs List

- EG: Entry guide stand
- BD1 to BD4: Breakdown roll stand
- CL1 to CL4: Cluster roll stand
- B: Base
- W. S.: Work side
- D. S.: Drive side
- 1: Gate-type frame
- 2: Up-and-down jack
- 3: Crossbeam
- 4: Up-and-down screw jack unit
- 5: Upper and lower roll unit
- 5a: Upper frame body
- 5b: Lower frame body
- 5c: Screw shaft
- 6: Columnar frame
- 7: Crossbeam stand
- 10: Column
- 11, 12: Flat roll
- 11a,: 12aRoll chock
- 13: Hydraulic unit
- 14: Bridge member
- 15: Up-and-down wedge unit
- 15a: Beam member
- 15b: Wedge member
- 15c: Up-and-down member
- 20: Upper and lower roll
- 21, 22, 31, 32, 51, 52: Upper roll
- 23, 24: Lower roll
- 25, 55: Lower center roll
- 53, 54: Side roll
- 61, 62, 71, 72, 81, 82, 91, 92: Cluster side roll
- 63, 64: Center bending roll

## Claims

1. A manufacturing apparatus for a welded pipe that is a forming mill comprising a breakdown forming section (BD) configured for performing bending from opposite edge portions of a forming target raw material, the breakdown forming section comprising an edge bending forming system employing an involute curve partially in an upper roll caliber, and a forming roll for fit bending of bending the raw material in a region external to or internal to a pinch point in a width direction of the raw material where the raw material is pinched with upper and lower rolls (20) while making a fit to the upper roll (21,22)(31,32)(41,42)(51,52), and the forming mill further comprsing multi-use forming rolls in multiple stands (BD1-BD4) designed in a roll flower defining roll multi-use within a several-fold range in diameter ratio, **characterized in that**
the manufacturing apparatus has a configuration in which non-drive type breakdown rolls BD exclusive to bending are arranged in multiple stands (BD1-BD4), drive roll DR stands (DR1-DR5) exclusive to driving are arranged in stages in front of and behind each BD stand, and the drive roll DR is configured to apply thrust to a central portion of the raw material using an upper flat roll (11) and a lower flat roll (12), and **in that** it further comprises thrust control means and driving rotation number control means configured to apply thrust required for passage through the breakdown forming section using the drive rolls DR in multiple stages entirely and controlling the thrust.

2. The manufacturing apparatus for a welded pipe according to claim 1, wherein
the thrust control means includes a fluid pressure device (13) for applying load to the upper roll (11) of the drive roll and has load control means.

3. The manufacturing apparatus for a welded pipe according to claim 1, wherein
the upper and lower flat rolls (11,12) of the drive roll have shapes conforming to flatness at the central portion of the forming target raw material.

4. The manufacturing apparatus for a welded pipe according to any one of claims 1 to 3, wherein
a cluster mill with non-drive type four-direction or three-direction multi-use cluster roll stands (CL1-CL4) in multiple stages responsible for forming of a lower portion of the raw pipe by a circular bending system is arranged on a downstream side of the breakdown mill, and a fin-pass mill is arranged on a downstream side of the cluster mill to configure a pipe mill, the fin-pass mill including drive-type fin-pass roll stands (FP1-FP3) in multiple stages for forming into an approximately circular shape in preparation for a squeeze step, and having position control means for controlling the position of a fin-pass roll in the stand and driving rotation number control means for the fin-pass roll,
the manufacturing apparatus having thrust distribution control means for distributing thrust required for passage through each step of forming of the forming target raw material into a round pipe to a drive roll (DR) group in multiple stages of the breakdown mill and a fin-pass roll group in multiple stages of the fin-pass mill to apply thrust from the drive roll and the fin-pass roll to the forming target raw pipe and control the thrust.

5. The manufacturing apparatus for a welded pipe according to claim 4, wherein
the thrust distribution control means is arithmetic means that operates each of the thrust control means and the driving rotation number control means for the drive roll (DR) group, the position control means for controlling the position of the fin-pass roll in the stand, and the driving rotation number control means for the fin-pass roll in line with distribution information about the thrust.

6. A manufacturing method for a welded pipe wherein
in a breakdown step of performing bending from opposite edge portions of a forming target raw material by an edge bending forming system by employing an involute curve partially in an upper roll caliber, and using a forming roll for fit bending of bending the raw material in a region external to or internal to a pinch point in a width direction of the raw material where the raw material is pinched with upper and lower rolls (20) while making a fit to the upper roll (21,22)(31,32)(41,42)(51,52), and using multi-use forming rolls in multiple stands (BD1-BD4) designed in a roll flower defining roll multi-use within a several-fold range in diameter ratio, **characterized by**
using a breakdown mill having a configuration in which non-drive type breakdown rolls BD exclusive to bending are arranged in multiple stands (BD1-BD4), drive roll DR stands (DR1-DR5) exclusive to driving are arranged in stages in front of and behind each BD stand, and the drive roll DR applies thrust to a central portion of the raw material using an upper flat roll (11) and a lower flat roll (12), and having thrust control means and driving rotation number control means for applying thrust required for passage through the breakdown forming section using the drive rolls DR in multiple stages entirely and controlling the thrust,
on the basis of result of simulation analysis conducted on a forming process of forming from the forming target raw material into a semi-circular pipe in response to a difference in type or dimension within a range of multi-use on the assumption of the breakdown mill having the forming roll stand configuration and to be operated by an identified procedure, thrust information required for edge bending in the breakdown step responsive to the forming target raw material is acquired and thrust is applied to the forming target raw plate using the drive rolls DR entirely.

7. A manufacturing method for a welded pipe wherein
in a breakdown step of performing bending from opposite edge portions of a forming target raw material by an edge bending forming system by employing an involute curve partially in an upper roll caliber, and using a forming roll for fit bending of bending the raw material in a region external to or internal to a pinch point in a width direction of the raw material where the raw material is pinched with an upper roll and a lower roll while making a fit to the upper roll (21,22)(31,32)(41,42)(51,52), and using multi-use forming rolls in multiple stands (BD1-BD4) designed in a roll flower defining roll multi-use within a several-fold range in diameter ratio, in a subsequent circular bending step of bending into a circular cylindrical shape through center bending, and in a subsequent fin-pass roll forming step of forming into a required circular shape by fixing end surface shapes at edge portions of the raw pipe intended to form butting contact therebetween, **characterized by**
using a pipe mill including:
a breakdown mill having a configuration in which non-drive type breakdown rolls BD exclusive to bending are arranged in multiple stands (BD1-BD4), drive roll DR stands (DR1-DR4) exclusive to driving are arranged in stages in front of and behind each BD stand, and the drive roll DR applies thrust to a central portion of the raw material using an upper flat roll (11) and a lower flat roll (12), and having thrust control means and driving rotation number control means for applying thrust required for passage through the breakdown forming section using the drive rolls DR in multiple stages entirely and controlling the thrust; and
a cluster mill arranged on a downstream side of the breakdown mill and including non-drive type four-direction or three-direction multi-use cluster roll stands (CL1-CL4) in multiple stages responsible for forming of a lower portion of the raw pipe by a circular bending system, and a fin-pass mill arranged on a downstream side of the cluster mill, including drive-type fin-pass roll stands (FP1-FP3) in multiple stages for forming into an approximately circular shape in preparation for a squeeze step, and having position control means for controlling the position of a fin-pass roll in the stand and driving rotation number control means for the fin-pass roll,
on the basis of result of simulation analysis conducted on a forming process of forming from the forming target raw material into a circular pipe in response to a difference in type or dimension within a range of multi-use on the assumption of the pipe mill having the forming roll stand configuration and to be operated by an identified procedure, thrust information required for forming in each of the forming steps responsive to the forming target raw material is acquired and thrust is applied to the forming target raw pipe using a stand group of the drive rolls DR and a stand group of the fin-pass rolls FP.

8. The manufacturing method for a welded pipe according to claim 6 or 7, wherein the upper and lower flat rolls of the drive roll in the breakdown mill have shapes conforming to flatness at the central portion of the forming target raw material.

## Patentansprüche

1. Vorrichtung zur Herstellung eines geschweißten Rohrs, bei der es sich um ein Formwalzwerk handelt, aufweisend einen Vorformungsabschnitt (breakdown forming section; BD), der konfiguriert ist, um ein Biegen von gegenüberliegenden Kantenbereichen eines zu formenden Rohmaterials durchzuführen, wobei der Vorformungsabschnitt ein Kantenbiege-Formungssystem, das teilweise eine Evolventenkurve in einem oberen Walzenkaliber verwendet, sowie eine Formwalze zum Formanpassungsbiegen des Rohmaterials in einem Gebiet außerhalb oder innerhalb eines Klemmpunkts in Breitenrichtung des Rohmaterials aufweist, an welchem das Rohmaterial mit oberen und unteren Walzen (20) geklemmt wird, während eine Formanpassung an die obere Walze (21, 22) (31, 32) (41, 42) (51, 52) erfolgt, und wobei das Formwalzwerk weiter Mehrzweck-Formwalzen in mehreren Gerüsten (BD1-BD4) aufweist, die in einer Walzblume ausgeführt sind, welche eine Mehrzweckverwendung der Walzen innerhalb eines Bereichs eines mehrfachen Durchmesserverhältnisses definiert, **dadurch gekennzeichnet, dass**
die Herstellungsvorrichtung eine Konfiguration aufweist, bei der nicht angetriebene Vorformwalzen BD, die ausschließlich zum Biegen dienen, in mehreren Gerüsten (BD1-BD4) angeordnet sind, Antriebswalzen-(DR)-Gerüste (DR1-DR5), die ausschließlich zum Antreiben dienen, in Stufen vor und hinter jedem BD-Gerüst angeordnet sind, und die Antriebwalze DR konfiguriert ist, um eine Schubkraft auf einen zentralen Abschnitt des Rohmaterials unter Verwendung einer oberen ebenen Walze (11) und einer unteren ebenen Walze (12) aufzubringen, sowie dadurch, dass sie weiter eine Schubkraftsteuereinrichtung und eine Antriebsdrehzahlsteuereinrichtung aufweist, die konfiguriert sind, um die für das Durchlaufen des Vorformungsabschnitts erforderliche Schubkraft vollständig unter Verwendung der Antriebswalzen DR in mehreren Stufen aufzubringen und die Schubkraft zu steuern.

2. Vorrichtung zur Herstellung eines geschweißten Rohrs nach Anspruch 1, bei der
die Schubkraftsteuereinrichtung eine Fluiddruckvorrichtung (13) zum Aufbringen einer Last auf die obere Walze (11) der Antriebswalze aufweist und eine Laststeuereinrichtung aufweist.

3. Vorrichtung zur Herstellung eines geschweißten Rohrs nach Anspruch 1, bei der
die oberen und unteren ebenen Walzen (11, 12) der Antriebswalze Formen aufweisen, die mit einer Ebenheit im zentralen Abschnitt des zu formenden Rohmaterials übereinstimmen.

4. Vorrichtung zur Herstellung eines geschweißten Rohrs nach einem der Ansprüche 1 bis 3, bei der
ein Cluster-Walzwerk mit nicht angetriebenen Vierrichtungs- oder -Dreirichtungs-Mehrzweck-Cluster-Walzgerüsten (CL1-CL4) in mehreren Stufen, die für die Formung eines unteren Abschnitts des Rohrohrs durch ein System zum kreisförmigen Biegen zuständig sind, auf einer in Vorschubrichtung dahinter liegenden Seite des Vorformungswalzwerks angeordnet ist und ein Fin-Pass-Walzwerk auf einer in Vorschubrichtung dahinter liegenden Seite des Cluster-Walzwerks angeordnet ist, um ein Rohrwalzwerk zu konfigurieren, wobei das Fin-Pass-Walzwerk angetriebene Fin-Pass-Walzgerüste (FP1-FP3) in mehreren Stufen zur Ausbildung einer annähernd kreisförmigen Form zur Vorbereitung eines Quetschschritts aufweist, und eine Positionssteuereinrichtung zum Steuern der Position einer Fin-Pass-Walze im Gerüst und eine Drehzahlsteuereinrichtung für die Fin-Pass-Walze aufweist,
wobei die Herstellungsvorrichtung eine Schubkraftverteilungssteuereinrichtung aufweist, um die Schubkraft, die zum Durchlaufen eines jeden Schrittes der Formung des zu formenden Rohmaterials zu einem runden Rohr erforderlich ist, auf eine Antriebswalzengruppe (DR-Gruppe) in mehreren Stufen des Vorformwalzwerks und eine Fin-Pass-Walzengruppe in mehreren Stufen des Fin-Pass-Walzwerks zu verteilen, um die Schubkraft von der Antriebswalze und der Fin-Pass-Walze auf das zu formende Rohrohr aufzubringen und die Schubkraft zu steuern.

5. Vorrichtung zur Herstellung eines geschweißten Rohrs nach Anspruch 4, bei der
die Schubkraftverteilungssteuereinrichtung eine Recheneinrichtung ist, die jede der folgenden, und zwar die Schubkraftsteuereinrichtung und die Antriebsdrehzahlsteuereinrichtung für die Antriebswalzengruppe (DR-Gruppe), die Positionssteuereinrichtung zum Steuern der Position der Fin-Pass-Walze im Gerüst, und die Antriebsdrehzahlsteuereinrichtung für die Fin-Pass-Walze, entsprechend den Verteilungsinformationen betreffend die Schubkraft betreibt.

6. Verfahren zur Herstellung eines geschweißten Rohrs, bei dem
ein Vorformungsschritt, bei dem ein Biegen von gegenüberliegenden Kantenabschnitten eines zu formenden Rohmaterials durch ein Kantenbiege-Formungssystem unter Verwendung einer Evolventenkurve teilweise in einem oberen Walzenkaliber durchgeführt wird, und bei dem eine Formwalze zum Formanpassungsbiegen des Rohmaterials in einem Gebiet außerhalb oder innerhalb eines Klemmpunkts in Breitenrichtung des Rohmaterials verwendet wird, bei welchem das Rohmaterial mit oberen und unteren Walzen (20) geklemmt wird, während eine Formanpassung an die obere Walze (21, 22) (31, 32) (41, 42) (51, 52) bewirkt wird, und bei dem Mehrzweck-Formwalzen in mehreren Gerüsten (BD1-BD4) verwendet werden, die in einer Walzblüte ausgeführt sind, welche eine Mehrzweckverwendung der Walzen innerhalb eines Bereichs eines mehrfachen Durchmesserverhältnisses definiert, durchgeführt wird, **gekennzeichnet durch**
Verwenden eines Vorformwalzwerks, das eine Konfiguration aufweist, bei der nicht angetriebene Vorformwalzen BD, die ausschließlich zum Biegen dienen, in mehreren Gerüsten (BD1-BD4) angeordnet sind, wobei Antriebswalzen-(DR)-Gerüste (DR1-DR5), die ausschließlich zum Antreiben dienen, in Stufen vor und hinter jedem BD-Gerüst angeordnet sind, und die Antriebswalze DR eine Schubkraft auf einen zentralen Abschnitt des Rohmaterials unter Verwendung einer oberen ebenen Walze (11) und einer unteren ebenen Walze (12) aufbringt und eine Schubkraftsteuereinrichtung und eine Antriebsdrehzahlsteuereinrichtung aufweist, um die zum Durchlaufen des Vorformungsabschnitts erforderliche Schubkraft vollständig unter Verwendung der Antriebswalzen DR in mehreren Stufen aufzubringen und die Schubkraft zu steuern,
basierend auf dem Ergebnis einer Simulationsanalyse, die für einen Formungsprozess, bei dem das zu formende Rohmaterial zu einem halbkreisförmigen Rohr geformt wird, ansprechend auf Unterschiede in Bezug auf Typ oder Abmessung innerhalb eines Mehrzweckverwendungsbereichs unter der Annahme durchgeführt wird, dass das Vorformwalzwerk die Formungswalzgerüstkonfiguration aufweist und mittels einer identifizierten Prozedur betrieben wird, die Information betreffend die Schubkraft, die für das Kantenbiegen beim Formungsschritt erforderlich ist, entsprechend dem zu formenden Rohmaterial ermittelt wird und die Schubkraft auf die zu formende Rohplatte vollständig unter Verwendung der Antriebsrollen DR aufgebracht wird.

7. Verfahren zur Herstellung eines geschweißten Rohrs, bei dem
ein Vorformungsschritt, bei dem ein Biegen von gegenüberliegenden Kantenabschnitten eines zu formenden Rohmaterials durch ein Kantenbiege-Formungssystem unter Verwendung einer Evolventenkurve teilweise in einem oberen Walzenkaliber durchgeführt wird, und bei dem eine Formwalze zum Formanpassungsbiegen des Rohmaterials in einem Gebiet außerhalb oder innerhalb eines Klemmpunkts in Breitenrichtung des Rohmaterials verwendet wird, bei welchem das Rohmaterial mit einer oberen Walze und einer unteren Walze geklemmt wird, während eine Formanpassung an die obere Walze (21, 22) (31, 32) (41, 42) (51, 52) bewirkt wird, und bei dem Mehrzweck-Formwalzen in mehreren Gerüsten (BD1-BD4) verwendet werden, die in einer Walzblüte ausgeführt sind, welche eine Mehrzweckverwendung der Walzen innerhalb eines Bereichs eines mehrfachen Durchmesserverhältnisses definiert, ein nachfolgender Schritt eines kreisförmigen Biegens, bei dem ein Biegen in eine kreisförmige zylindrische Form durch zentrales Biegen erfolgt, und ein nachfolgender Schritt einer Formung durch Fin-Pass-Walzen, bei dem ein Formen zu einer erforderlichen kreisförmigen Form durch Fixieren von Endflächenformen an Kantenabschnitten des Rohrohrs, die einen stumpf anstoßenden Kontakt zwischen diesen bilden sollen, durchgeführt werden, **gekennzeichnet durch**
Verwenden eines Rohrwalzwerks, aufweisend:
ein Vorwalzwerk, das eine Konfiguration aufweist, bei der nicht angetriebene Vorformwalzen BD, die ausschließlich zum Biegen dienen, in mehreren Gerüsten (BD1-BD4) angeordnet sind, Antriebswalzen-(DR)-Gerüste (DR1-DR4), die ausschließlich zum Antreiben dienen, in Stufen vor und hinter jedem BD-Gerüst angeordnet sind und die Antriebwalze DR eine Schubkraft auf einen zentralen Abschnitt des Rohmaterials unter Verwendung einer oberen ebenen Walze (11) und einer unteren ebenen Walze (12) aufbringt und eine Schubkraftsteuereinrichtung und eine Antriebsdrehzahlsteuereinrichtung aufweist, welche die für das Durchlaufen des Vorformungsabschnitts erforderliche Schubkraft vollständig unter Verwendung der Antriebswalzen DR in mehreren Stufen aufbringt und die Schubkraft steuert; und
ein Cluster-Walzwerk auf einer in Vorschubrichtung dahinter liegenden Seite des Vorformungswalzwerks angeordnet ist und nicht angetriebene Vierrichtungs- oder -Dreirichtungs-Mehrzweck-Cluster-Walzgerüste (CL1-CL4) in mehreren Stufen beinhaltet, die für die Formung eines unteren Abschnitts des Rohrohrs durch ein System zum kreisförmigen Biegen zuständig sind, und ein Fin-Pass-Walzwerk auf einer in Vorschubrichtung dahinter liegenden Seite des Cluster-Walzwerks angeordnet ist, welches angetriebene Fin-Pass-Walzgerüste (FP1-FP3) in mehreren Stufen zur Ausbildung einer annähernd kreisförmigen Form zur Vorbereitung eines Quetschschritts aufweist, und eine Positionssteuereinrichtung zum Steuern der Position einer Fin-Pass-Walze im Gerüst und eine Drehzahlsteuereinrichtung für die Fin-Pass-Walze aufweist,
basierend auf dem Ergebnis einer Simulationsanalyse, die für einen Formungsprozess, bei dem das zu formende Rohmaterial zu einem halbkreisförmigen Rohr geformt wird, ansprechend auf Unterschiede in Bezug auf Typ oder Abmessung innerhalb eines Mehrzweckverwendungsbereichs unter der Annahme durchgeführt wird, dass das Rohrwalzwerk die Formungswalzgerüstkonfiguration aufweist und mittels einer identifizierten Prozedur betrieben wird, die Information betreffend die Schubkraft, die für das Formen bei jedem der Formungsschritte erforderlich ist, entsprechend dem zu formenden Rohmaterial ermittelt wird und die Schubkraft auf das zu formende Rohrohr unter Verwendung einer Gerüstgruppe der Antriebswalzen DR und einer Gerüstgruppe der Fin-Pass-Walzen FP aufgebracht wird.

8. Verfahren zur Herstellung eines geschweißten Rohrs nach Anspruch 6 oder 7, bei dem
die oberen und unteren ebenen Walzen der Antriebswalze im Vorwalzwerk Formen aufweisen, die mit einer Ebenheit im zentralen Abschnitt des zu formenden Rohmaterials übereinstimmen.

## Revendications

1. Appareil de fabrication pour un tube soudé qui est un laminoir de formage comprenant une section de formage de dégrossissement (BD) configurée pour réaliser un pliage à partir des parties de bords opposés d'une matière première cible de formage, la section de formage de dégrossissement comprenant un système de formage de pliage de bord utilisant une courbe involute partiellement dans un calibre de rouleau supérieur et un rouleau de formage pour le pliage ajusté consistant à plier la matière première dans une zone externe ou interne à un point de pincement dans une direction de largeur de la matière première où la matière première est pincée avec des rouleaux supérieurs et inférieurs (20) tout en s'ajustant au rouleau supérieur (21, 22) (31, 32) (41, 42) (51, 52), et le laminoir de formage comprenant en outre des rouleaux de formage multi-usages dans plusieurs cages (BD1-BD4) conçues dans un modèle de rouleaux en fleur définissant un usage multiple des rouleaux dans une plage de plusieurs fois le rapport de diamètre, **caractérisé en ce que**
l'appareil de fabrication présente une configuration dans laquelle des rouleaux de dégrossissement BD de type sans entraînement dédiés au pliage sont agencés dans plusieurs cages (BD1-BD4), des cages de rouleaux d'entraînement DR (DR1-DR5) dédiés à l'entraînement sont agencées en étages devant et derrière chaque cage de BD, et le rouleau d'entraînement DR est configuré pour appliquer une poussée à une partie centrale de la matière première à l'aide d'un rouleau plat supérieur (11) et d'un rouleau plat inférieur (12), et **en ce qu'**il comprend en outre des moyens de commande de poussée et des moyens de commande du nombre de rotations d'entraînement configurés pour appliquer entièrement la poussée nécessaire au passage à travers la section de formage de dégrossissement à l'aide des rouleaux d'entraînement DR dans plusieurs étages et en commandant la poussée.

2. Appareil de fabrication pour un tube soudé selon la revendication 1, dans lequel
les moyens de commande de poussée comportent un dispositif de pression de fluide (13) pour appliquer une charge au rouleau supérieur (11) du rouleau d'entraînement et présentent des moyens de commande de charge.

3. Appareil de fabrication pour un tube soudé selon la revendication 1, dans lequel
les rouleaux plats supérieurs et inférieurs (11, 12) du rouleau d'entraînement présentent des formes se conformant à la planéité sur la partie centrale de la matière première cible de formage.

4. Appareil de fabrication pour un tube soudé selon l'une des revendications 1 à 3, dans lequel
un laminoir à rouleaux multiples avec des cages de groupement ramassé de rouleaux multi-usages dans quatre directions ou trois directions de type sans entraînement (CL1-CL4) dans plusieurs étages responsables du formage d'une partie inférieure du tube brut par un système de pliage circulaire est agencé sur un côté aval du laminoir dégrossisseur, et un laminoir à cannelures de guidage est agencé sur un côté aval du laminoir à rouleaux multiples pour configurer un laminoir à tubes, le laminoir à cannelures de guidage comportant des cages de rouleau à cannelures de guidage de type à entraînement (FP1-FP3) dans plusieurs étages pour une transformation en une forme approximativement circulaire en préparation d'une étape de compression, et présentant des moyens de commande de position pour commander la position d'un rouleau à cannelures de guidage dans la cage et des moyens de commande du nombre de rotations d'entraînement pour le rouleau à cannelures de guidage,
l'appareil de fabrication présentant des moyens de commande de distribution de poussée pour distribuer la poussée nécessaire au passage par chaque étape de transformation de la matière première cible de formage en un tube rond vers un groupe de rouleaux d'entraînement (DR) dans plusieurs étages du laminoir dégrossisseur et un groupe de rouleaux à cannelures de guidage dans plusieurs étages du laminoir à cannelures de guidage afin d'appliquer la poussée provenant du rouleau d'entraînement et du rouleau à cannelures de guidage au tube brut cible de formage et commander la poussée.

5. Appareil de fabrication pour un tube soudé selon la revendication 4, dans lequel
les moyens de commande de distribution de poussée sont des moyens arithmétiques qui actionnent chacun des moyens de commande de poussée et des moyens de commande du nombre de rotations d'entraînement pour le groupe de rouleaux d'entraînement (DR), des moyens de commande de position pour commander la position du rouleau à cannelures de guidage dans la cage, et des moyens de commande du nombre de rotations d'entraînement pour le rouleau à cannelures de guidage en ligne avec des informations de distribution sur la poussée.

6. Procédé de fabrication pour un tube soudé dans lequel dans une étape de dégrossissement consistant à réaliser un pliage à partir des parties de bords opposés d'une matière première cible de formage par un système de formage de pliage de bord en utilisant une courbe involute partiellement dans un calibre de rouleau supérieur, et à l'aide d'un rouleau de formage pour le pliage ajusté consistant à plier la matière première dans une zone externe ou interne à un point de pincement dans une direction de largeur de la matière première où la matière première est pincée avec des rouleaux supérieurs et inférieurs (20) tout en s'ajustant au rouleau supérieur (21, 22) (31, 32) (41, 42) (51, 52), et à l'aide des rouleaux de formage multi-usages dans plusieurs cages (BD1-BD4) conçues dans un modèle de rouleaux en fleur définissant un usage multiple des rouleaux dans une plage de plusieurs fois le rapport de diamètre, **caractérisé par**
utiliser un laminoir dégrossisseur présentant une configuration dans laquelle des rouleaux de dégrossissement BD de type sans entraînement dédiés au pliage sont agencés dans plusieurs cages (BD1-BD4), des cages de rouleaux d'entraînement DR (DR1-DR5) dédiés à l'entraînement sont agencées dans des étages devant et derrière chaque cage de BD, et le rouleau d'entraînement DR applique une poussée à une partie centrale de la matière première à l'aide d'un rouleau plat supérieur (11) et d'un rouleau plat inférieur (12), et présentant des moyens de commande de poussée et des moyens de commande du nombre de rotations d'entraînement pour appliquer la poussée nécessaire au passage à travers la section de formage de dégrossissement à l'aide des rouleaux d'entraînement DR dans plusieurs étages dans son ensemble et commander la poussée,
sur la base du résultat d'une analyse de simulation effectuée sur un processus de formage consistant à transformer la matière première cible de formage en un tube semi-circulaire en réponse à une différence de type ou de dimension dans une plage multi-usages en supposant que le laminoir dégrossisseur présente la configuration de cage de rouleau de formage et doit être exploité selon une procédure identifiée, des informations de poussée nécessaires au pliage des bords lors de l'étape de dégrossissement en fonction de la matière première cible de formage sont acquises et une poussée est appliquée à la plaque brute cible de formage à l'aide des rouleaux d'entraînement DR dans son ensemble.

7. Procédé de fabrication pour un tube soudé dans lequel dans une étape de dégrossissement consistant à réaliser un pliage à partir de parties de bords opposés d'une matière première cible de formage par un système de formage de pliage de bord en utilisant une courbe involute partiellement dans un calibre de rouleau supérieur, et à l'aide d'un rouleau de formage pour le pliage ajusté consistant à plier la matière première dans une région externe ou interne à un point de pincement dans une direction de largeur de la matière première où la matière première est pincée avec un rouleau supérieur et un rouleau inférieur tout en s'ajustant au rouleau supérieur (21, 22) (31, 32) (41, 42) (51, 52), et à l'aide de rouleaux de formage multi-usages dans plusieurs cages (BD1-BD4) conçus dans un modèle de rouleaux en fleur définissant un usage multiple des rouleaux dans une plage de plusieurs fois le rapport de diamètre, dans une étape de pliage circulaire ultérieure de pliage en une forme cylindrique circulaire par pliage central, et dans une étape de formage par rouleau à cannelures de guidage ultérieure consistant à effectuer une transformation en une forme circulaire requise par fixation des formes de surface d'extrémité sur des parties de bord du tube brut destinées à former un contact de butée entre elles, **caractérisé par**
utiliser un laminoir à tubes comportant :
un laminoir dégrossisseur présentant une configuration dans laquelle des rouleaux de dégrossissement BD de type sans entraînement dédiés au pliage sont agencés dans plusieurs cages (BD1-BD4), des cages de rouleaux d'entraînement DR (DR1-DR4) dédiés à l'entraînement sont agencées dans des étages devant et derrière chaque cage de BD, et le rouleau d'entraînement DR applique une poussée à une partie centrale de la matière première à l'aide d'un rouleau plat supérieur (11) et d'un rouleau plat inférieur (12), et présentant des moyens de commande de poussée et des moyens de commande du nombre de rotations d'entraînement pour appliquer la poussée nécessaire au passage à travers la section de formage de dégrossissement à l'aide des rouleaux d'entraînement DR dans plusieurs étages dans son ensemble et commander la poussée ; et
un laminoir à rouleaux multiples agencé sur un côté aval du laminoir dégrossisseur et comportant des cages de groupement ramassé de rouleaux multi-usages dans quatre directions ou trois directions de type sans entraînement (CL1-CL4) dans plusieurs étages responsables du formage d'une partie inférieure du tube brut par un système de pliage circulaire, et un laminoir à cannelures de guidage agencé sur un côté aval du laminoir à rouleaux multiples, comportant des cages de rouleaux à cannelures de guidage de type à entraînement (FP1-FP3) dans plusieurs étages pour la transformation en une forme approximativement circulaire en préparation d'une étape de compression, et présentant des moyens de commande de position pour commander la position d'un rouleau à cannelures de guidage dans la cage et des moyens de commande du nombre de rotations d'entraînement pour le rouleau à cannelures de guidage,
sur la base du résultat d'une analyse de simulation effectuée sur un processus de formage consistant à transformer la matière première cible de formage en un tube circulaire en réponse à une différence de type ou de dimension dans une plage multi-usages en supposant que le laminoir à tubes présente la configuration de cage de rouleaux de formage et doit être exploité selon une procédure identifiée, des informations de poussée nécessaires au formage dans chacune des étapes de formage en fonction de la matière première cible de formage sont acquises et une poussée est appliquée au tube brut cible de formage à l'aide d'un groupe de cages des rouleaux d'entraînement DR et d'un groupe de cages des rouleaux à cannelures de guidage FP.

8. Procédé de fabrication pour un tube soudé selon la revendication 6 ou 7, dans lequel
les rouleaux plats supérieurs et inférieurs du rouleau d'entraînement dans le laminoir dégrossisseur présentent des formes se conformant à la planéité sur la partie centrale de la matière première cible de formage.
